# EUROPEAN PATENT APPLICATION

(11) **EP 4 800 691 A1**
(43) Date of publication of application: **02.09.2026**
(21) Application number: 26161367.3
(22) Date of filing: 27.02.2026
(51) Int. Cl.: G11C 11/54, G11C 13/00

(54) **HIGH SIGNAL-TO-NOISE-RATIO MEMORY CELL PROGRAMMING FOR IN-MEMORY COMPUTING**

(30) Priority: 28.02.2025 US 202563765420 P; 19.12.2025 US 202519427834
(71) Applicant: OmniVision Technologies, Inc., Santa Clara California 95054 (US)
(72) Inventor: SAITO, Daisuke, Santa Clara, 95054 (US)
(74) Representative: Dehns Germany Partnerschaft mbB

(57) **Abstract**

An in-memory computing system (200) includes a cross-bar array (414, 514) of memory cells (402), each having a cell transistor (702) and a memristor (502) connected in series between a select line (704) and a bit line (706). A group of programming transistors (1102), located outside the cross-bar array (514) and fewer in number than the memory cells, is selectively connected in parallel with cell transistors (702) of a common row during a write mode and isolated during a read mode. This configuration increases programming current without enlarging a footprint of the cross-bar array, enabling multi-level conductance states and improved signal-to-noise ratio for analog in-memory computing. In some embodiments, the in-memory computing system is integrated with an image sensor die for on-sensor inference.

## Description

### FIELD

The present application is directed to in-memory computing circuitry.

### RELATED APPLICATION

This application claims priority to US Patent Application Serial Number 63/765,420, titled "High Signal-to-Noise-Ratio Memory Cell programming for In-Memory Computing," filed February 28, 2025.

### BACKGROUND

Deep neural networks (DNNs) require large amounts of memory, where data is read from the memory, processed, and then stored in the memory. This bottleneck between digital memory and a processing unit is well known for computers using the von Neumann architecture. Over 60% of power and time for a DNN computational problem is spent moving data between the memory and the processing unit - more than the power and time spent processing the data.

In-memory computing is emerging as one way of overcoming this bottleneck, particularly for DNN acceleration. Breaking the memory wall is seen as a way to enable massive computational parallelism for use by DNN. The use of alternative memory devices, such as the memristor, offer further advantages to DNN.

### SUMMARY

Analog in memory computing (AIMC) implements multiply accumulate (MAC) operations directly within memory arrays to reduce data movement and improve energy efficiency for deep neural network (DNN) workloads. However, AIMC circuits suffer from reduced signal to noise ratio (SNR) compared to digital computing due to process, voltage, and temperature (PVT) variations and the stochastic nature of analog components. The present embodiments addresses these limitations by introducing a memory array architecture and programming method that improves SNR and signal to quantization noise ratio (SQNR) without sacrificing array density or reliability. While examples herein illustrate AIMC integrated with image sensors, the disclosed architecture and methods apply to any embedded AI hardware that uses AIMC for matrix vector multiplication, including AI ASICs, on sensor real time processors, and always on low power inference engines. For AI ASICs, hardware acceleration of DNN using AIMC benefits from improved SNR, enabling higher inference accuracy at constant energy per MAC. For on sensor real-time computing, ROI detection and metadata generation require low latency and low power; improved SNR reduces error propagation in early layers, maintaining accuracy under aggressive quantization. For always on low power AI, event detection circuits operate under strict energy budgets; improved SNR allows fewer verify iterations and stable multi-level programming, reducing standby power.

The present invention is defined in the appended claims. Embodiments of the present invention are subject-matter of the dependent claims. One aspect of the present embodiments includes the realization that good separation between programmed conductance levels in memory cells of a one-transistor-one-resistor (1T1R) array is desired to reduce bit error when the 1T1R array is used for in-memory computing. To support multi level conductance programming (e.g., 16 or more levels) in 1T1R memory cells, and/or to increase separation between programmed conductance levels, higher programming current is required. Increasing the size of the cell transistor or altering the array layout would introduce fabrication non-uniformity and routing complexity, degrading reliability and density. Conventional solutions such as pairing two 1T1R cells in parallel reduce density by disconnecting one memristor. The disclosed architecture avoids these drawbacks by adding a second transistor external to the array and sharing it across multiple cells, providing additional current only during write mode while preserving 1T1R read characteristics.

The disclosed architecture solves two coupled problems: (i) insufficient programming current in compact 1T1R cells for multi level conductance storage, and (ii) SNR degradation in AIMC due to poor level separation and PVT variability. By introducing an external assist transistor shared across multiple cells and isolating it during read, the design increases programming current without enlarging cell transistors or altering array routing, thereby maintaining density and reliability. Experimental and simulated results show improved level separability (A ≥ 6 for 16 levels) and SQNR gains of 4-8 dB, enabling higher inference accuracy at constant energy.

In certain embodiments, the techniques described herein relate to an in-memory computing system with high signal-to-noise-ratio memory cell programming, including: a computational block formed with a cross-bar array of memory cells, wherein each memory cell includes a cell transistor and a memristor connected in series between a select line (SL) and a bit line (BL); and a group of programming transistors located outside a main body of the cross-bar array and fewer in number than the memory cells, wherein each programming transistor is selectively connected in parallel with a plurality of cell transistors of a common row during a write mode of the memory cell and is isolated from the cell transistors when the memory cells are not in the write mode.

In certain embodiments, the techniques described herein relate to a method for high signal-to-noise-ratio programming of memory cell for in-memory computing, including: fabricating a 1T1R array of memory cells that each include one cell transistor and one memristor connected in series between a bit line (BL) and a select line (SL); fabricating a group of programming transistors external to the 1T1R array, wherein each of the programming transistors is electrically coupled in parallel with at least one different one of the cell transistors; fabricating, for each programming transistor, an isolating switch coupled in series with the programming transistor; and controlling each of the programming transistors to provide at least part of a programming current for at least one of the memristors during a write mode of the memristor and controlling the corresponding isolating switch to electrically disconnect the programming transistor from the memory cells when not during the write mode.

### BRIEF DESCRIPTION OF THE FIGURES

In the drawings, identical reference numbers identify similar elements or acts. The sizes and relative positions of elements in the drawings are not necessarily drawn to scale. For example, the shapes of various elements and angles are not drawn to scale, and some of these elements are arbitrarily enlarged and positioned to improve drawing legibility. Further, the particular shapes of the elements as drawn, are not intended to convey any information regarding the actual shape of the particular elements, and have been solely selected for ease of recognition in the drawings.
FIG. 1 is a schematic of a prior art computing system, implemented using the von Neumann architecture, for processing image data captured by an image sensor.
FIG. 2 is a schematic of one example analog in-memory computation (AIMC) system for processing image data from an image sensor, in embodiments.
FIG. 3 is a schematic illustrating one example deep neural network (DNN) for processing the image data of FIG. 2 to generate an inference, in embodiments.
FIG. 4 is a schematic illustrating one example computational memory that performs matrix vector multiplication (MVM), in embodiments.
FIG. 5 is a schematic illustrating one example computational memory implemented in a current-domain technology, in embodiments.
FIGs. 6A and 6B illustrate example digital and analog truncation, respectively, of ADC captured values from the output conductors of FIG. 4, in embodiments.
FIGs. 7, 8 and 9 illustrate conventional structure and operation of the memristor of FIG. 5, in embodiments.
FIG. 10 shows two graphs that illustrate programming of the memristor of FIG. 5 with discernable conductance levels, in embodiments.
FIG. 11 is a circuit diagram illustrating one example 2T1R memory array architecture with additional programming transistors that are each shared between multiple cells of one row of the array, in embodiments.
FIG. 12 is a circuit diagram illustrating a programming cycle of the 2T1R memory array architecture of FIG. 11, in embodiments.
FIG. 13 is a circuit diagram illustrating a reset cycle of the 2T1R memory array architecture of FIG. 11, in embodiments.
FIG. 14 is a circuit diagram illustrating a read cycle of the 2T1R memory array architecture of FIG. 11, in embodiments.
FIG. 15 is a circuit diagram of a portion of one example 2T1R memory array architecture with additional programming transistors that are each shared between multiple cells of one row of the array, and controlled by a separate write line, in embodiments.
FIG. 16 is a circuit diagram of a portion of one example 2T1R memory array architecture, that is similar to the 2T1R memory array architecture of FIG. 15, but has fewer write lines, in embodiments.
FIG. 17 is a circuit diagram of the 2T1R memory array architecture of FIG. 11 illustrating a read mode, in embodiments.
FIG. 18 is a circuit diagram illustrating two memory cell groups of the 2T1R memory array architecture of FIG. 11, that form at least part of the cross-bar array of FIG. 4, in embodiments.
FIG. 19A is a schematic diagram illustrating one example integration of the computational memory of FIG. 4 with an image sensor, in embodiments.
FIG. 19B is a schematic diagram illustrating example functionality between the image sensor and the ASIC die of FIG. 19A, in embodiments.
FIG. 20 is a flowchart illustrating one example method for high signal-to-noise-ratio programming of memory cell for in-memory computing, in embodiments.

### DETAILED DESCRIPTION OF THE EMBODIMENTS

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known structures associated with scanners, safety laser scanners, computers, processors (hardware processors) memory or other storage have not been shown or described in detail to avoid unnecessarily obscuring descriptions of the various implementations and embodiments.

Unless the context requires otherwise, throughout the specification and claims which follow, the word "comprise" and variations thereof, such as, "comprises" and "comprising" are to be construed in an open, inclusive sense that is as "including, but not limited to."

Reference throughout this specification to "one implementation" or "an implementation" or "one embodiment" or "an embodiment" means that a particular feature, structure or characteristic described in connection with the embodiment is included in at least one implementation or embodiment. Thus, the appearances of the phrases "one implementation" or "an implementation" or "in one embodiment" or "in an embodiment" in various places throughout this specification are not necessarily all referring to the same implementation or embodiment. Furthermore, the particular features, structures, or characteristics may be combined in any suitable manner in one or more implementations or one or more embodiments.

As used in this specification and the appended claims, the singular forms "a," "an," and "the" include plural referents unless the content clearly dictates otherwise. It should also be noted that the term "or" is generally employed in its sense including "and/or" unless the content clearly dictates otherwise.

Analog in-memory computing (AIMC) is an attractive solution to achieve low power/high efficiency operation with a small on-chip foot print for multiply accumulations, which is a main part of computations used by deep neural networks (DNNs). For example, AIMC implements analog multiply-accumulate cells (MACs) that provide a low-power and high efficiency alternative to digital computing. However, analog MACs have a lower signal-to-noise ratio (SNR) as compared to digital computing because of process, voltage, and temperature (PVT) variation across the analog MACs. Propagation of this noise to subsequent parts of the DNN may impact results and/or performance of the DNN. The present embodiments teach of methods for improving the SNR of AIMC such that the AIMC outputs may be successfully used in the subsequent parts of the DNN.

Although the following examples illustrate the user of AIMC with image sensors, the SNR improvement is not limited to use with image sensors and may be applied to AIMC used in any kinds of embedded AI hardware that uses AIMC.

The following three use-cases are provided as examples. (1) Artificial intelligence (AI) application-specific integrated circuits (ASICs) support common DNN and frameworks by providing hardware accelerated by AIMC. This is relatively high performance area in the edge computing field, and security is a main application. Through use of the disclosed noise reduction for mixed in-memory computing, a high efficiency and higher accuracy computing is achieved. (2) On-sensor real-time computing is used for determining a region of interest (ROI) within an image, where the on-sensor real-time computing generates meta data for the sensed image. On-sensor real-time computing (e.g., on-the-fly computing) is used in augmented reality (AR), virtual reality (VR), and automotive applications for example. Advantageously, the disclosed noise reduction for mixed in-memory computing achieves low-power and higher accuracy computing operation. (3) Always-on low-power AI may be embedded in sensors that operate continuously (e.g., always on). Such embedded sensors are used for event detection in applications including security, doorbells, etc. Advantageously, the disclosed noise reduction for mixed in-memory computing allows AIMC to achieve low-power with higher accuracy computation than with prior, noisier, circuitry.

The traditional von Neumann architecture includes a digital data bus that couples memory with a processing unit, where the processing unit fetches a value from memory, processes that value, and then stores the result back in the memory.

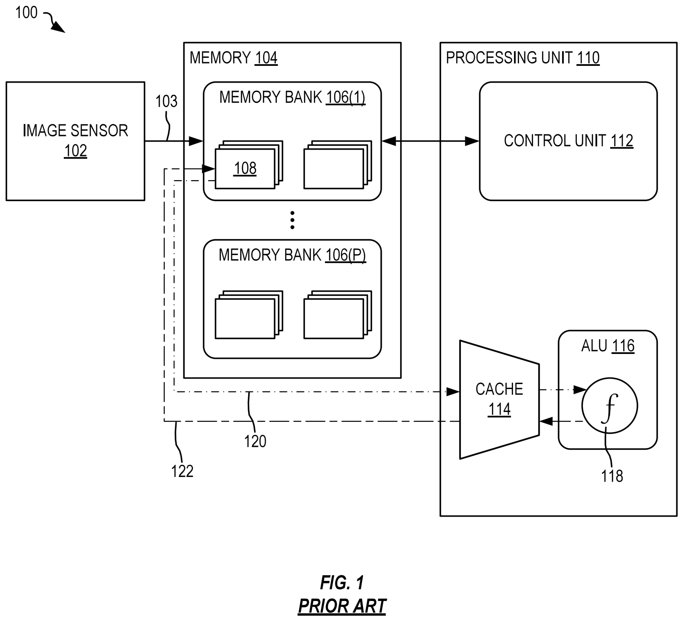

FIG. 1 is a schematic of a prior art computing system 100, implemented using the von Neumann architecture, for processing image data 103 captured by an image sensor 102. Prior art computing system 100 includes a memory 104 with a plurality of memory banks 106(1)-106(P) and a processing unit 110 with a control unit 112, a cache 114, and an arithmetic logic unit (ALU) 116. Image data 103 is received from image sensor 102 and stored in cells 108 of memory bank 106(1). Control unit 112 causes a read 120 to transfer data of cell 108 to ALU 116, via cache 114, where ALU 116 implements a function 118 (e.g., a mathematical operation) on the data. Control unit 112 then causes a write 122 to transfer the resulting data back to cell 108 (or a different cell) of memory 104. In this architecture, function 118 is implemented external to memory 104, and as known in the art, read 120 and write 122 of data from and to memory 104 causes a significant bottleneck for memory intensive computation as required by a DNN.

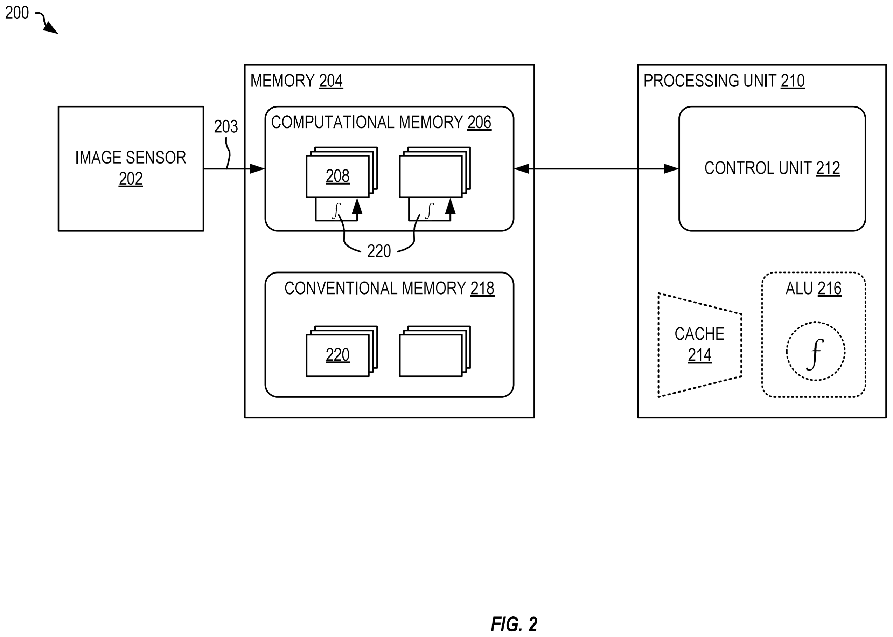

FIG. 2 is a schematic of one example analog in-memory computation (AIMC) system 200 for processing image data 203 from an image sensor 202, in embodiments. AIMC system 200 includes memory 204 with computational memory 206 and a processing unit 210 with a control unit 212, a cache 214, and an ALU 216. Computational memory 206 includes a plurality of cells 208 that are individually programmed to implement function 220 on data input to computational memory 206 as directed by control unit 212. Advantageously, function 220 is applied to data of cells 208 within computational memory 206 concurrently and without the need to move the data between memory 204 and processing unit 210. By way of example, transfer of data from Dynamic Randon Access Memory (DRAM) consumes over 600 picojoules (pJ) and transfer of data from SRAM consumes approximately 5-50 pJ. In contrast, in-memory computing (IMC) consumes sub-pJ. Accordingly, cache 214 and ALU 216 are not used to implement function 220 in this embodiment.

As shown in FIG. 2, memory 204 may also include conventional memory 218 in a von Neumann configuration where data is moved between conventional memory 218 and processing unit 210 using reads and writes. Accordingly, system 200 implements both AIMC within computational memory 206 and conventional data processing of data in conventional memory 218 using ALU 216.

With the increased demand for artificial intelligence processing, a data and thereby memory intensive type of processing for deep neural networks, the power required by data processing centers increases. Computational memory 206 reduces the power requirement by implementing function 220 in-memory and thereby avoiding repeated movement of data (e.g., read 120 and write 122 of FIG. 1) between memory 204 and a separate processing unit 210. Computational memory 206 provides fast, low-power computing with a small footprint that allows on-chip integration.

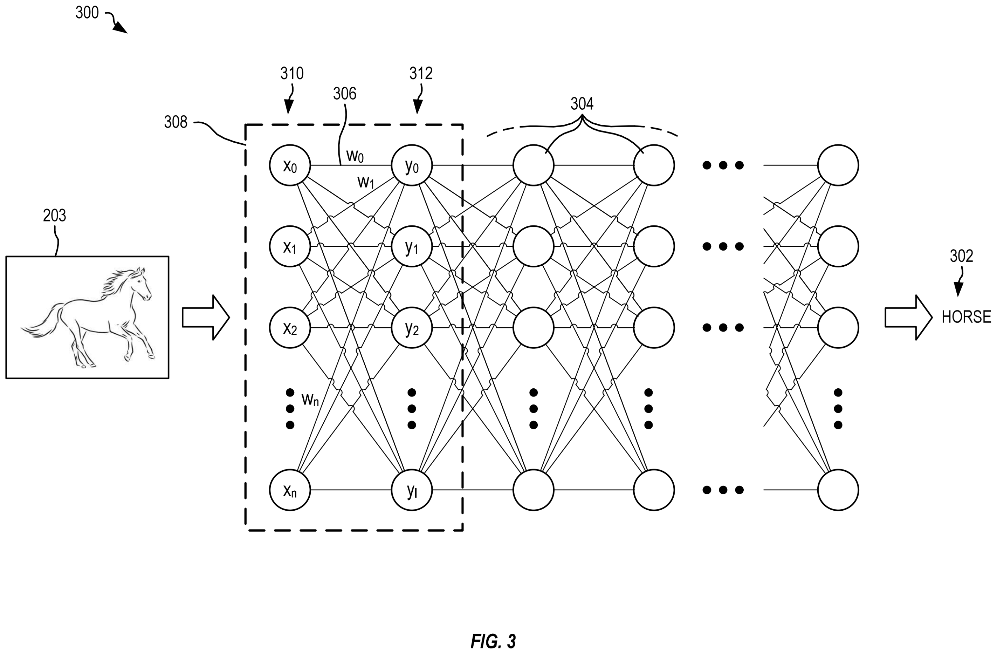

FIG. 3 is a schematic illustrating one example DNN 300 for processing image data 203 of FIG. 2 to generate an inference 302, which in this example indicates whether image data 203 includes an image of a horse. DNN 300 includes a plurality of multiply-accumulate cells (MACs) 304 (shown as circles), where each MAC 304 multiplies inputs from other cells by an associated weight 306 for each other cell, represented as lines between MACs 304, and accumulates the results. Per convention for a first layer 308 of DNN 300, an input array 310 of MACs 304 is referenced as *x*₀ through *xₙ* and an output array 312 (e.g., a next column of MACs 304 of DNN 300) is references as y₀ through y*ₗ*, where *y*₀ through y*ₗ* are the input array of a next layer of DNN 300. Weights 306 are referenced as *w*₀ through *wₙ* where *w*₀ represents weight 306 applied to a value received by *y*₀ from *x*₀, *w*₁ represents weight 306 applied to a value received by *y*₀ from *x*₁, and so on.

Following this convention, equation (1) illustrates function 220 to calculate *y*₀. ${y}_{0} = \vec{x} ⋅ {{W}^{⇀}}^{T} = \left[{x}_{1} ⋯ {x}_{j} ⋯ {x}_{n}\right] ⋅ \left[\begin{matrix}{w}_{0} \\ ⋮ \\ {w}_{j} \\ ⋮ \\ {w}_{n}\end{matrix}\right] = {\sum }_{j = 0}^{N - 1} {x}_{j} ⋅ {w}_{j}$

That is, equation (1) only calculates a value for *y*₀. The number of MACs 304 in each output array 312 for each layer 308 need not be the same as the number of MACs 304 in input array 310. That is, *l* is not required to equal *n* in FIG. 3.

### General

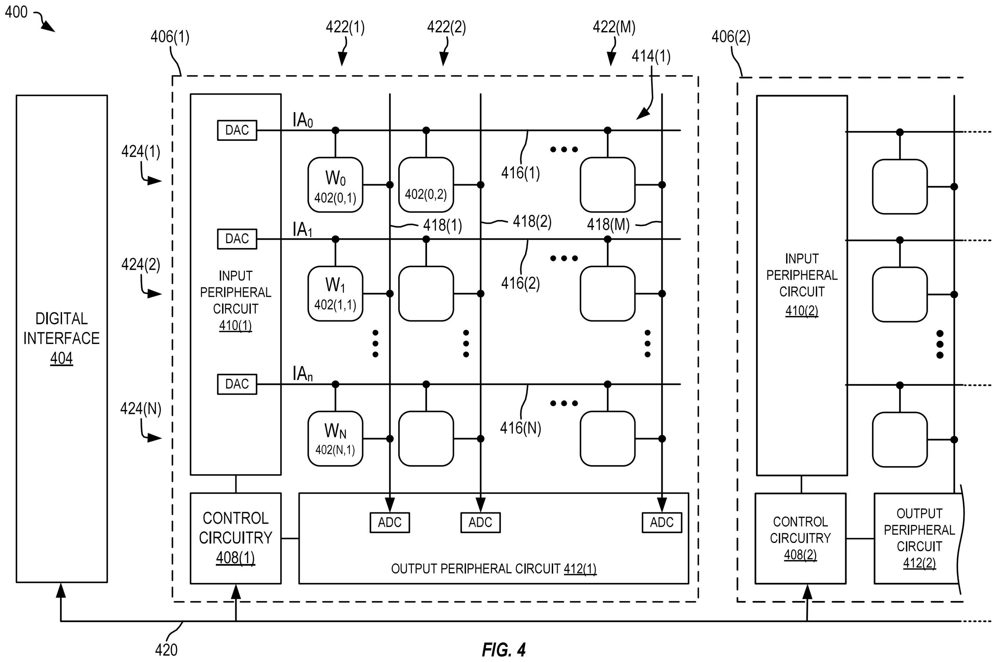

FIG. 4 is a schematic illustrating one example computational memory 400 that performs matrix vector multiplication (MVM), in embodiments. Computational memory 400 may represent computational memory 206 of FIG. 2.

Computational memory 400 includes a digital interface 404 and at least one computational block 406 (e.g., shown with computational block 406(1) and 406(2)), where each computational block 406 includes control circuitry 408 (e.g., control circuitry 408(1) and 408(2)), input peripheral circuits 410 (e.g., input peripheral circuits 410(1) and 410(2) that include input activation (IA) drivers and/or word line (WL) drivers), output peripheral circuits 412 (e.g., output peripheral circuits 412(1) and 412(2)), and a cross-bar array 414 (e.g., cross-bar array 414(1)) connecting a plurality of analog cells 402. Digital interface 404 provides communication, via a digital bus 420, between computational memory 400 and host devices for example. Cross-bar array 414(1) is formed as a grid of non-connecting conductors, that includes a plurality of input conductors 416(1)-416(N) and a plurality of output conductors 418(1)-418(M) such that computational block 406 has M columns (e.g., columns 422(1)-422(M)) and N rows (e.g., rows 424(1)-424(N)). Each cell 402 connects between one input conductor 416 and one output conductor 418, such that exactly one cell 402 connects between any pair of one input conductor 416 and one output conductor 418, as shown.

Control circuitry 408 implements a sequence controller that controls operation of each computational block 406, input peripheral circuits 410, output peripheral circuits 412, and cross-bar array 414 that performs MVM as used by DNN 300 of FIG. 3, for example. Control circuitry 408 controls input peripheral circuits 410 and/or output peripheral circuits 412 to program each cell 402 with a multiplier value, such as weight 306 of DNN 300. As shown in the example of FIG. 4, cell 402(0,1) is programed with weight *W*₀ and cell 402(1,1) is programed with weight *W*₁, and so on. The following examples use the digital weights of DNN 300 to represent the digital multipliers of cells 402.

Each cell 402 generates an analog output signal (e.g., current or charge) based on an IA input signal and the preloaded weight and since the output of cells 402 in one column 422 are coupled to one output conductor 418 the output signals (e.g., current or charge) on output conductor 418 are summed on that output conductor 418. The output signal is sensed within output peripheral circuits 412 by an analog-to-digital converter (ADC). The ADC may be implemented as a successive approximation register (SAR) ADC, or by other types of ADC without departing from the scope hereof. In certain embodiments, output peripheral circuits 412 includes one ADC per column. In other embodiments, output peripheral circuits 412 includes fewer ADCs that are multiplexed between multiple columns. Column 422 performs a MAC function represented by equation (2). $Q = {\sum }_{j = 0}^{N - 1} \left({V}_{j}⋅t\right) ⋅ {G}_{j}$

### Current-Domain Technology

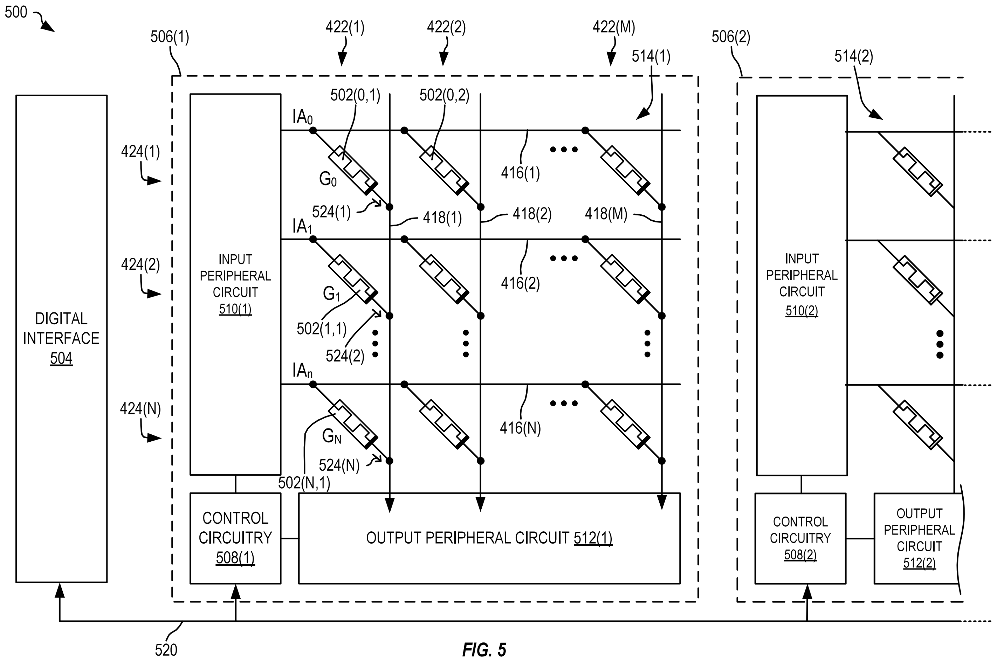

FIG. 5 is a schematic illustrating one example computational memory 500 implemented in a current-domain technology, in embodiments. Computational memory 500 is one example of computational memory 206 of FIG. 2. In this embodiment, each MACs 304 uses a memristor 502 that is preprogrammed with a gain representing a corresponding weight 306 of FIG. 3. However, computational memory 206 may be implemented using other technologies, such as a charge-domain technology that uses DRAM-IMC cells, SRAM, Flash, NVM (RRAM, PCM, STT-MRAM, SOT-MRAM, FeFET) for example. Although the following examples describe the use of memristors, other memory devices may be used without departing from the scope hereof. For example, memristor 502 is a two-terminal cell of any kind that has a memory function, such as a resistive random-access memory (ReRAM or RRAM).

Computational memory 500 includes a digital interface 504 and at least one computational block 506 (e.g., computational blocks 506(1) and 506(2)). Each computational block 506 includes control circuitry 508 (e.g., control circuitry 508(1) and 508(2)), input peripheral circuits 510 (e.g., input peripheral circuits 510(1) and 510(2)), output peripheral circuits 512 (e.g., output peripheral circuits 512(1) and 512(2)), and a cross-bar array 514 (e.g., cross-bar array 514(1)), formed as a grid of non-connecting conductors, that includes a plurality of input conductors 416(1)-416(N) and a plurality of output conductors 418(1)-418(M). Each one of the plurality of memristors 502 connects between one input conductor 416 and one output conductor 418, such that exactly one memristor 502 connects any pair of one input conductor 416 and one output conductor 418, as shown.

Computational memory 500 includes a communication bus 520 that connects digital interface 504 with control circuitry 508 of each computational block 506. Control circuitry 508 controls operation of input peripheral circuits 510 and output peripheral circuits 512 as describe in further detail below. Control circuitry 508 controls input peripheral circuits 510 and output peripheral circuits 512 to program each memristor 502 with a multiplier value, illustrated as a gain value corresponding to weight 306 of DNN 300. For example, memristor 502(0,1) is programed with gain *G*₀ that corresponds to weight *w*₀*,* and memristor 502(1,1) is programed with gain *G*₁ that corresponds to weight *w*₁, and so on.

In this example, computational block 506(1) implements functionality of first layer 308 of DNN 300 of FIG. 3, where a first column 422(1) of computational block 506(1) implements function 220 to determine a value of a first MAC 304 (e.g., *y*₀) of output array 312 based on inputs from input array 310 and weights *w*₀ - *wₙ*. In one example of operation, control circuitry 508(1) controls input peripheral circuits 510(1) to drive input conductor 416(1) with a voltage representing *x*₀, input conductor 416(2) with a voltage representing *x*₁, and so on. For example, input peripheral circuits 510 include digital-to-analog converters (DACs) that convert 8-bit input values of input array 310 (e.g., *x*₀*-xₙ*) into voltages that drive input conductors 416. Concurrently, memristor 502(0,1) multiplies the voltage on input conductor 416(1) by *G*₀ to generate a current 524(1) on output conductor 418(1), memristor 502(1,1) multiplies the voltage on input conductor 416(2) by *G*₁ to generate a current 524(2) on output conductor 418(1), ... and memristor 502(N,1) multiplies the voltage on input conductor 416(N) by *G_{N}* to generate a current 524(N) on output conductor 418(1). Other columns of computational block 506 operate similarly to generate output currents on corresponding output conductors 418. Control circuitry 508(1) then controls output peripheral circuits 512(1) to measure the current on output conductor 418(1) that represent a value for output array 312 (e.g., *y*₀-*yₗ*) of DNN 300. The current measured by output peripheral circuits 512(1) on output conductor 418(1) is the sum of currents 524(1)-(N), such that column 422(1) performs a MAC function. This is represented by equation (3). $I = {\sum }_{j = 0}^{N - 1} {V}_{j} ⋅ {G}_{j}$

### ADC Truncation

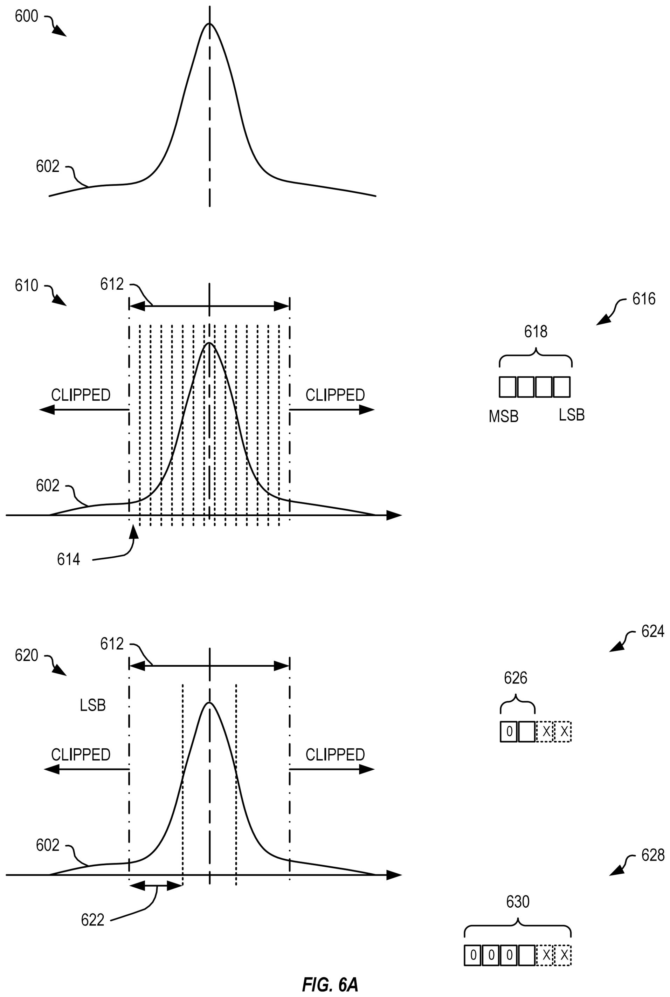

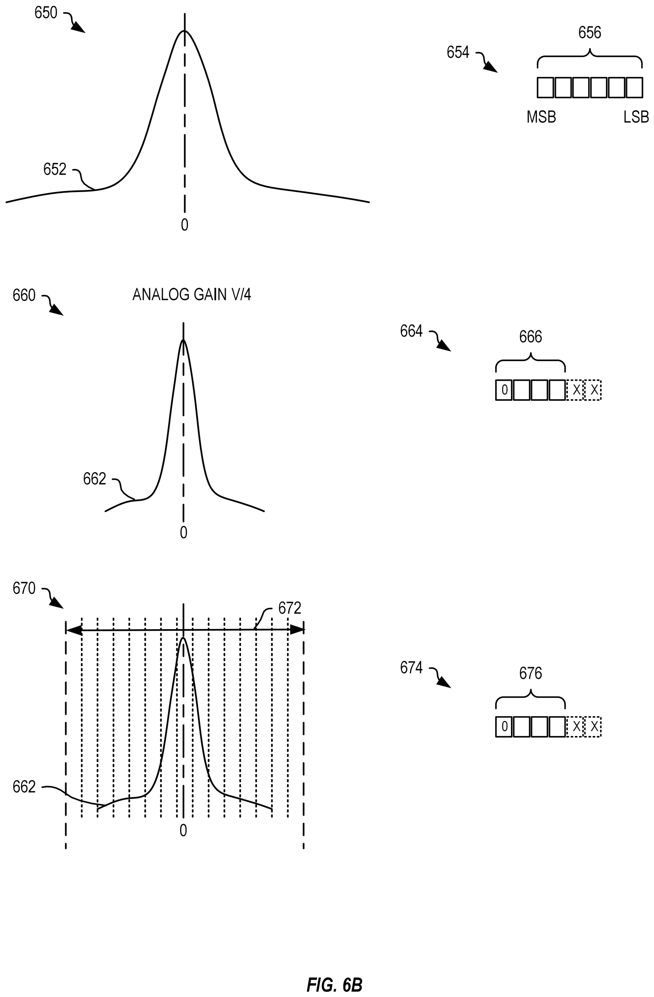

FIGs. 6A and 6B illustrate example digital and analog truncation, respectively, of ADC captured values from output conductors 418 of FIG. 4, in embodiments. For clarity of illustration, a four-bit ADC is illustrated; however, the ADC may have more or fewer bits without departing from the scope hereof.

As noted above, PVT and quantization errors introduce undesirable noise that propagates through DNN 300. Bit precision and range of captured values is controlled by selecting an appropriate ADC conversion range 612 that is tuned according to a distribution curve 602 of output of columns 422 of computational block 406 of FIG. 4 and a desired precision (e.g., four-bits). Quantization noise occurs in the LS bits of a captured value, and reducing this noise by truncation of LS bits improves SQNR. The truncation may be affected in either or both, the analog domain and the digital domain. In the digital domain, the number of bits captured by the ADC may be controlled such that LS bits are not captured and thus reducing noise. In the analog domain, a gain (e.g., V/4) may be applied to the analog signal prior to capture of a value by the ADC. Accordingly, the analog signal is reduced such that the noise is outside the capture range of the ADC.

In the digital level truncation example of FIG. 6A, graph 600 illustrates an example distribution curve 602 of the analog values of output conductors 418. Graph 610 illustrates a capture range 612 of the ADC that is positioned to capture the most important values of distribution curve 602. In this example, the analog signal and capture range 612 are not changed. As shown in graph 610, capture range 612 is divided into fifteen sub-ranges and the ADC captures a value 616 of four bits 618. Accordingly, a LSB of value 616 is defined with a corresponding LSB sub-range 614. Values outside capture range 612 are not captured by the ADC and are clipped.

Graph 620 illustrates distribution curve 602 and the same capture range 612, but where the ADC is controlled to capture a value 624 with only two-bits 626. Accordingly, capture range 612 is divided into three sub-ranges such that the ADC operates with an LSB defined with an LSB sub-range 622, which is four times the width of LSB sub-range 614. In another example, where a bit depth of an ADC is changed from six-bits to four-bits, without changing the capture range *V_dr* of the ADC, the LSB sub-range changes from *V_dr*/2⁶ to *V_dr*/2⁴*.* Additional bit shifting may be affected in either the digital or analog domain to generate a value 628 with the required number of bits 630.

In the analog level truncation example of FIG. 6B, graph 650 illustrates an example distribution curve 652 of the analog values of output conductors 418. In this example, the output distribution range corresponds to a value 654 that is captured in six bits 656. Graph 660 illustrates a narrowed distribution curve 662 after a gain of V/4 has been applied (e.g., to the analog output of output conductors 418), resulting in a reduced distribution range that, implements analog level truncation, where narrowed distribution curve 662 may be captured as a value 664 that requires four bits 666 as compared to six bits 656 of value 654. Graph 670 shows narrowed distribution curve 662 is within a capture range 672 of a four-bit ADC, such that narrowed distribution curve 662 is captured as ADC captured information 674 with four-bits 676, effectively truncating the two LS-bits.

This solution is particularly useful when the analog signal on output conductor 418 is greater than capture range 672 of the ADC. By applying a gain to reduce distribution curve 652 to narrowed distribution curve 662, important parts of the analog signal are shifted to be within capture range 672 and are therefore captured by the ADCs. Accordingly, information of the analog signal is effectively truncated.

### ReRAM Structure and Operation

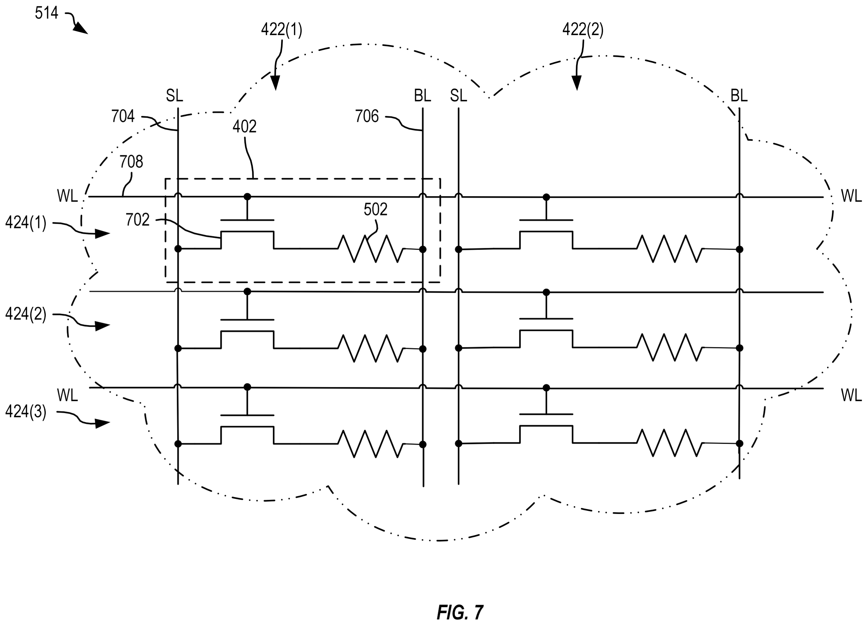

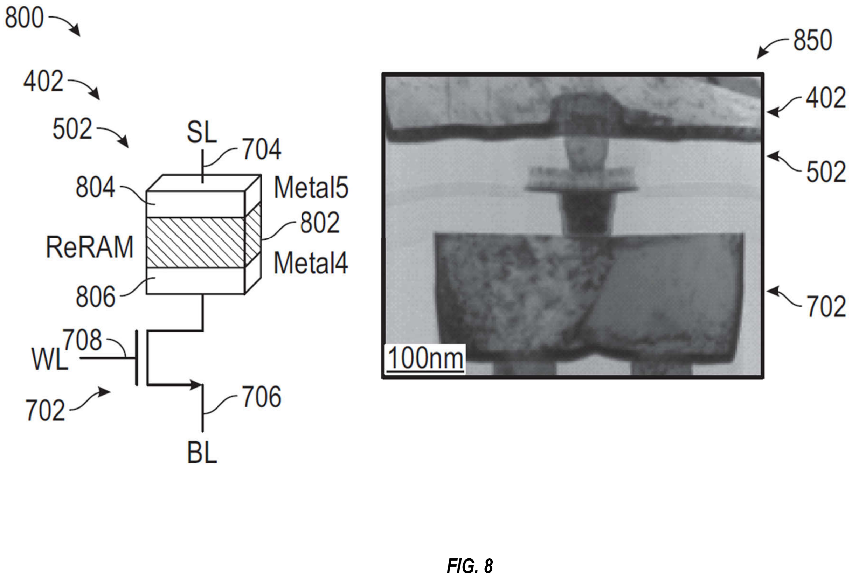

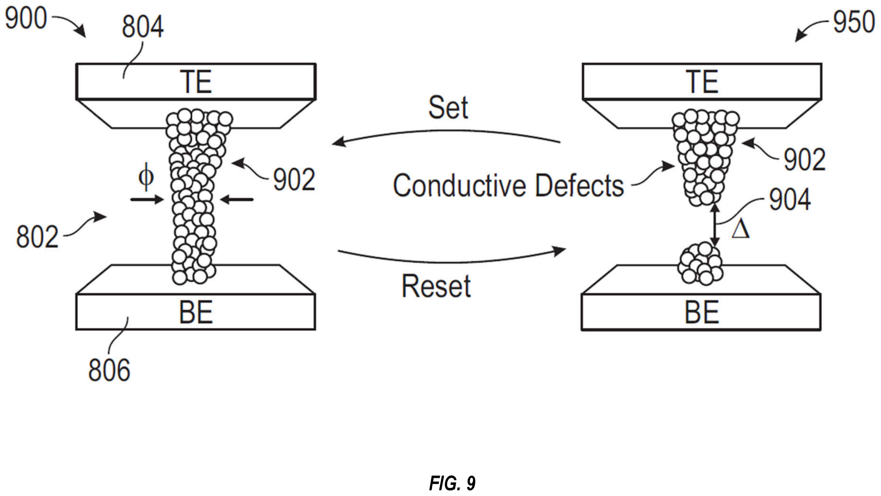

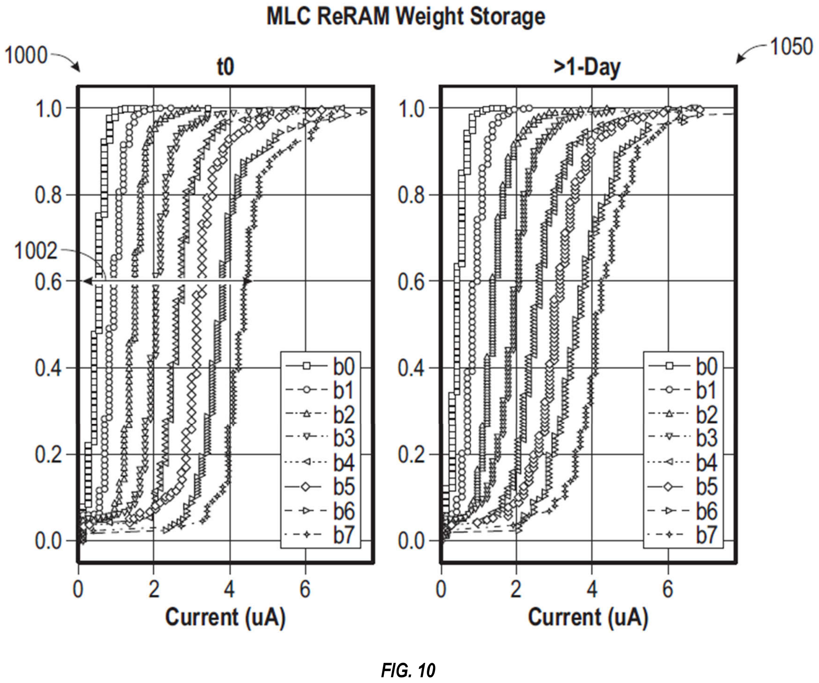

FIGs. 7, 8 and 9 illustrate conventional structure and operation of memristor 502 of FIG. 5. FIG. 7 is a circuit diagram illustrating a portion of cross-bar array 514 of FIG. 5. FIG. 8 shows a diagrammatic representation 800 of a physical structure of one cell 402 and a microscope cross-sectional image 850 of cell 402 of FIG. 7 as fabricated, in embodiments. FIG. 9 is a schematic representation of a high conductance state 900 and a low conductance state 950 of memristor 502 of FIGs. 5, 7 and 8, in embodiments. FIG. 10 shows two graphs 1000 and 1050 that illustrate programming of memristor 502 with discernable conductance levels, in embodiments. FIGs. 7, 8, 9, and 10 are best viewed together with the following description.

Cross-bar array 514 has one select line (SL) 704 for each column 422, one bit line (BL) 706 for each column 422, and one write line (WL) 708 for each row 424. SL 704, BL 706, and WL 708 control operation of cross-bar array 514. WL 708 represents input conductor 416 of FIGs. 4 and 5, and SL 704 represents output conductor 418. In the example of FIG. 7, cross-bar array 514 represents a 1T1R array where each memory cell 402 includes one cell transistor 702 (e.g., metal-oxide semiconductor field-effect transistor (MOSFET)) and one memristor 502 (e.g., ReRAM) that are connected in series between SL 704 and BL 706 of the column 422. For example, a source of cell transistor 702 connects with SL 704, a drain of cell transistor 702 connects with a first side of memristor 502, and a second side of memristor 502 connects with BL 706. WL 708 connects with a gate of cell transistors 702 of that row 424. That is, each SL 704 connects with cell transistors 702 of one column 422 of cross-bar array 514; each WL 708 connects with cell transistors 702 of one row 424 of cross-bar array 514; and each BL 706 connects with memristors 502 of one column of cross-bar array 514.

Diagrammatic representation 800 of FIG. 8 shows example structure of memristor 502 as a ReRAM layer 802 positioned between two metal layers 804 and 806, where layer 806 connects in series with cell transistors 702 (represented as a symbol). It is noted that connectivity of and positioning of memristor 502 and cell transistors 702 may be reversed without affecting operation of cell 402. Microscope cross-sectional image 850 illustrates how disruptive it would be to a memory array formed of cells 402 when a size of cell transistors 702 is increased or when a second transistor is added to cell 402. In certain embodiments, metal layers 804 and 806 are formed of one or more of Pt, Ta, Zr, Cu, Ag, Ni, TiN, Si, ITO, TaOₓ, TaₓOₓ, and TiOₓ, ReRAM layer 802 is formed of one or more of TaOₓ, TaₓOₓ, SiOₓN_{y}, a-Si, HfOₓ, TiOₓ, and Hf₁₋ₓAl₂ₓO₂₊ₓ, with a thickness of a few tens of nm. A forming voltage is < 5V with SET/RESET ranges of < 5V with a conductance < 1 mS and a compliance current < 1 mA. Variability data of memristor 502 has an endurance of up to 10¹² cycles and a retention of 10 years at 160 degrees.

In high conductance state 900 of FIG. 9, a continuous conductive filament 902 is formed between metal layer 804 and metal layer 806 such that resistance between metal layers 804 and 806 is low. In low conductance state 950, the conductive filament is not continuous between metal layers 804 and 806 the resistance between metal layers 804 and 806 is higher. The conductance/resistance between metal layers 804 and 806 is based on a gap 904 formed by conductive filament 902, where the size of gap 904 is determined by one or more of a polarity, a duration, and a strength of a programming current. For example, the greater the current, the shorter the programming pulse required to change the conductance level of the memristor between two levels. The polarity of the current defines the direction of change in the conductance level. For example, a first polarity increases the conductance and the reverse polarity decreases the conductance. Where the programming current is too low, the time required to change the memristor between two levels becomes too long, making the overall programming time for cross-bar array 514 unacceptable for use. For example, it is desired to use a current that allows a programming conductance below 10mS to provide the desired range of conductance change of memristor to implement the desired number of discernable levels. The driving current is limited by a size of cell transistors 702, which must be increased in size to increase the driving current. However, this increase in size would require an increase in size of cross-bar array 514, and would significantly disrupt engineered uniformity of the array, thereby increasing PVT and/or add parasitic errors.

Through use of RESET and SET programming cycles, memristor 502 may be programmed with a value (e.g., a eight bit value) that is represented as a conductance level (e.g., a resistance), where the conductance is programmed by passing a current through memristor 502 in a first direction to RESET the memristor and then passing a current through memristor in the reverse directions for a defined period to SET the memristor to a desired conductance level. Conventionally, two levels were programmed into each cell 402, whereby cross-bar array 514 formed a conventional data memory that stored binary values. Accordingly, the size of cell transistor 702 was selected to provide sufficient current to program memristor 502 with two discernable conductance levels, which further simplified fabrication of the memory. However, unlike conventional digital memory that stores two values (e.g., a binary value of zero or one), memristor 502 may be programmed with multiple discernable conductance levels to represent more than two values. The value stored in the cell is read out by determining the conductance level of memristor 502. For example, memristor 502 may be used to store eight values (e.g., representing values 0-7 - effectively storing a three bit value), each value represented as a difference conductance level. However, the number of levels that may be stored in memristor 502 is limited by the ability to reliably discern between the programmed conductance levels, which in turn is limited by the programming current provided by cell transistor 702. Graph 1000 of FIG. 10 shows eight discernable and repeatable conductance levels (labelled as b0 through b7) as illustrated by separation 1002. The key point is how to increase the conductance range at 1 LSB. 1 LSB is defined by "Total programmable conductance range / number of programming levels".

This conductance range at 1 LSB determines the possible programming levels. If you scale the array, you will need to make smaller transistors, which drive a limited current scaled by the transistor's width and length. This limited current constrains the possible improvement of the programable conductance range at 1LSB. When the number of programming levels increases without changing total programmable conductance range, the conductance range per 1 LSB will decrease, therefore the possible programming levels are limited by circuit PVT, which limits the programming accuracy. The simple formula is: (total variation from circuit and memristor) < (1 LSB conductance range). To get below 1ppm, 1 LSB would be less than 4 sigma of variation, assuming that the variation is Gaussian distribution.

### A Need for Greater Programming Current

Where cross-bar array 514 is used for in-memory computing to implement DNN 300 of FIG. 3 for inference, for example, it is noted that low precision quantization of four bits is usable and that and 8 bit precision is sufficient. In fact, larger DNN models show reasonable accuracy when using only three-bits of precision. However, it is more difficult to achieve reasonable accuracy with low-precision quantization for compact models (e.g., MobileNet, SqueezeNet, etc.) where there is noticeable degradation when using less than four-bit precision. According, it is desirable to store at least sixteen or more values in each cell 402.

As the number of values to be stored in memristor 502 increases, a greater programming current is required to achieve good separation between the different conductance levels to make them discernable when reading memristor 502 or using memristor 502 for in-memory computing. That is, the current required to program memristor 502 with sixteen discernable levels is greater than the current required to program memristor 502 with eight discernable levels for a given programming period. Accordingly, in a conventional 1T1R memory array, the current provided by a single cell transistor 702 limits the number of discernable conductance levels (e.g., values) that may be stored in memristor 502.

To increase the number of discernable values being stored by memristor 502, an increased programming current is desired, which requires that either cell transistor 702 is increased in size or a second transistor is added. However, to minimize risk of device fabrication non-uniformity and the corresponding risk of reliability degradation, it is undesirable to change the size of cell transistor 702 or memristor 502 that forms each cell 402. It is also undesirable to make significant changes to the layout and routing of cross-bar array 514. Thus, the solutions of increasing the size of cell transistors 702 and adding a second transistor to each cell 402 are unacceptable.

One solution that reduces the risk of device fabrication non-uniformity and resulting degradation in reliability, would be to pair two adjacent cells of a 1T1R layout to form a parallel connection of the two transistors, thereby making a wider channel width to handle an increased programming current. However, this would require one memristor 502 of the paired cells to be disconnected, which would decrease density of the memory array (e.g., by at least half) and is therefore also an unacceptable solution.

### Modified 2T1R Array

The present embodiments provide an improved solution that implements a 2T1R memory array with reduced risk of device fabrication non-uniformity and resulting degradation in reliability, by adding a second transistor, external to the main body of cross-bar array 514, that is shared over multiple cells.

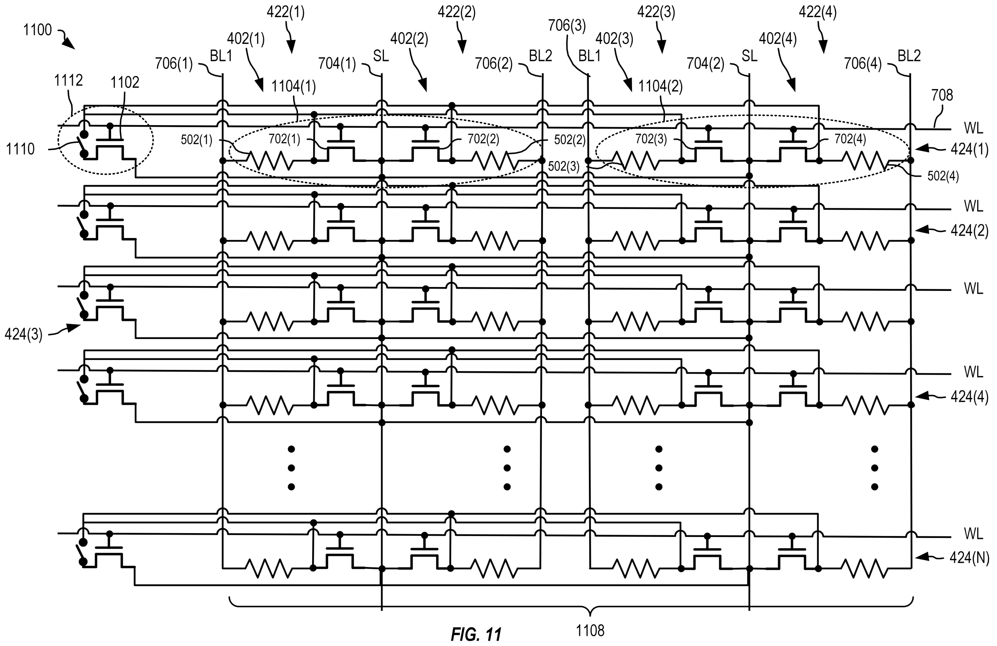

FIG. 11 is a circuit diagram illustrating one example 2T1R memory array architecture 1100 with additional programming transistors 1102 that are each shared between multiple cells 402(1)-402(4) of one row 424 of the array, in embodiments. Each cell 402 has one cell transistor 702 and one memristor 502 that are connected in series between SL 704 and a corresponding BL 706. For example, cell transistor 702(1) and memristor 502(1) are connected in series with each other and between SL 704 and BL 706(1); and cell transistor 702(2) and memristor 502(2) are connected in series with each other and between SL 704(1) and BL 706(2). Similarly, cell transistor 702(3) and memristor 502(3) are connected in series with each other and between SL 704(2) and BL 706(3); and cell transistor 702(4) and memristor 502(4) are connected in series with each other and between SL 704(2) and BL 706(4).

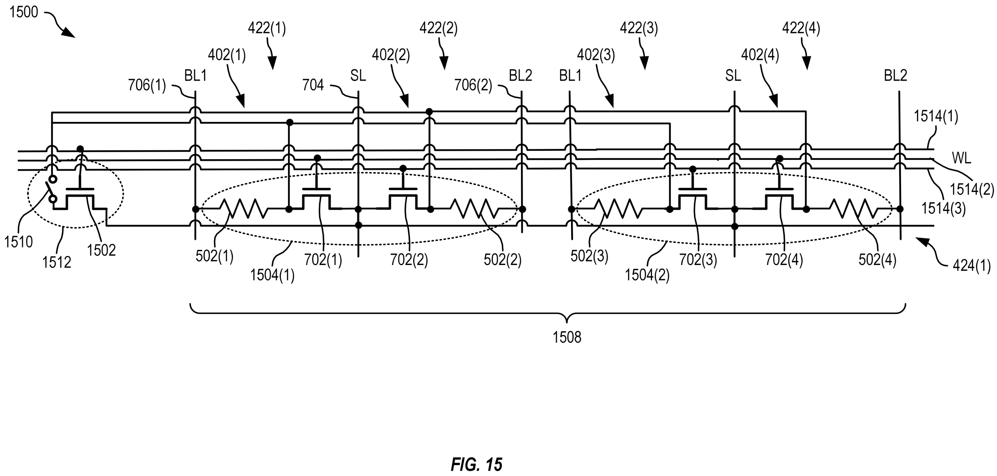

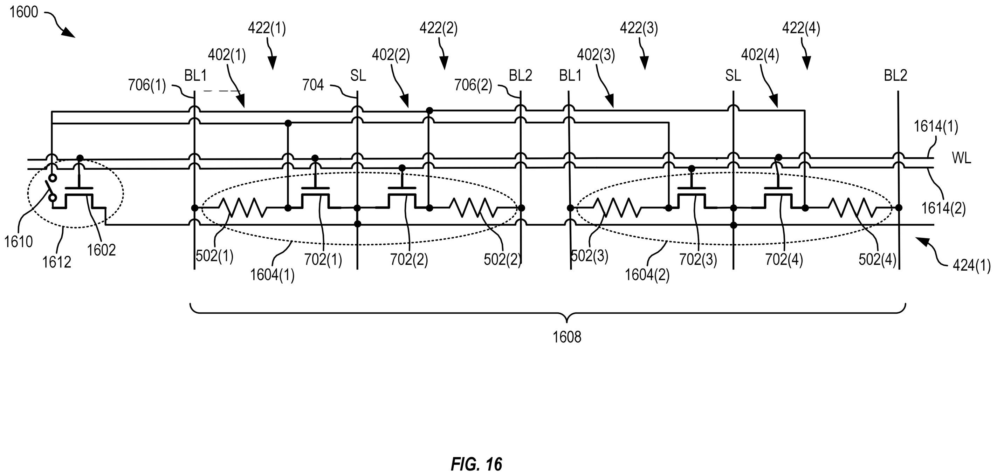

For fabrication, additional programming transistors 1102 are located external to a main body 1108 of cells 402 of 2T1R memory array architecture 1100. The leakage current of additional programming transistors 1102 may be mitigated by choosing appropriate voltage conditions of BL, SL, WL and/or by changing circuit topology, such as shown in FIGs. 15 and 16.

Accordingly, a size of additional programming transistors 1102 is not restricted by constraints of main body 1108 and it does not cause fabrication non-uniformity of main body 1108. Thus, main body 1108 of 2T1R memory array architecture 1100 is similar to a conventional 1T1R memory array, and the risk of device fabrication non-uniformity and the corresponding risk of reliability degradation is not increased by the inclusion of additional programming transistors 1102.

In the example of FIG. 11, adjacent cells are formed as a cell pair 1104 and share a common SL 704. Cell pair 1104(1) is formed of cells 402(1) and 402(2) and cell pair 1104(2) is formed of cell 402(3) and cell 402(4). Advantageously, two cells 402 of cell pair 1104 may be programmed simultaneously, where a voltage applied to the corresponding BL 706 controls programming conditions (e.g., values) of memristor 502. For example, to program memristors 502(1) and 502(2) with different values, a first voltage corresponding to a first value is applied to BL 706(1) and a second voltage corresponding to a second value is applied to BL 706(2) during a programming cycle of cell pair 1104. Example programming conditions include a programming voltage at SL of < 4 V, a WL voltage of < 4 V, and a current of < 1 mA per column where the programming duration is < 1ms per cell.

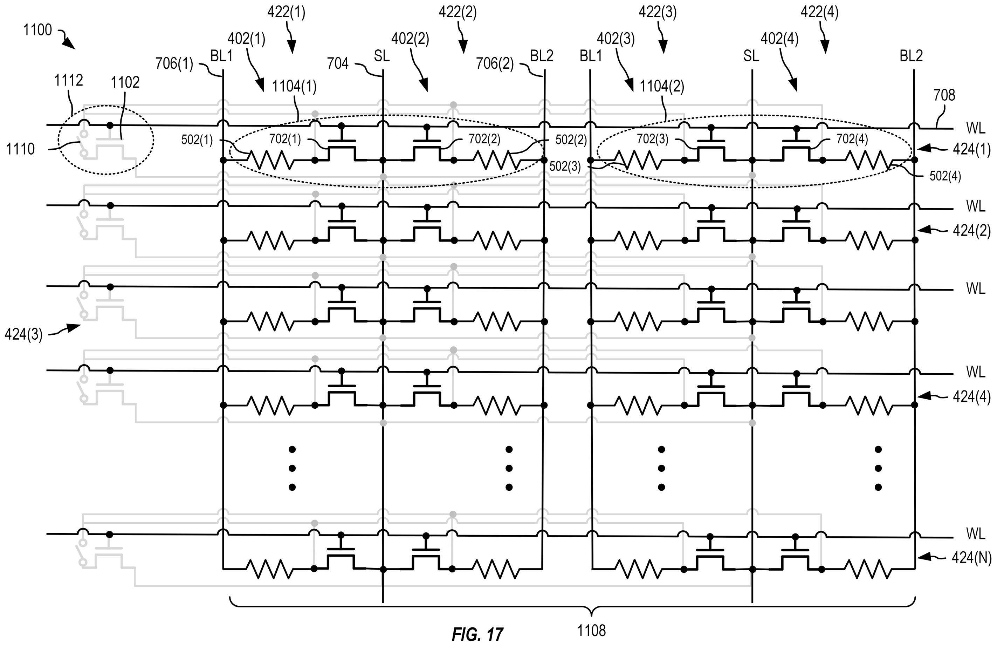

A gate of programming transistor 1102 connects with WL 708 of its row 424. A drain of programming transistor 1102 connects with SL 704 of each column 422, effectively connecting the drain of programming transistor 1102 to the drain of cell transistors 702 of that row. In the example of FIG. 11, additional programming transistors 1102 is assigned to row 424(1) and columns 422(1)-422(4). An isolation switch 1110 is included for each additional programming transistors 1102 to selectively connect a source of programming transistor 1102 with a source of each cell transistors 702 of its row 424. Isolation switch 1110 is closed programming of cells 402 of row 424(1) to connect additional programming transistor 1102 in parallel with each cell transistor 702 of the row. Isolation switch 1110 is open when cells 402 are not being programmed (e.g., a read operation and shown in FIG. 17). Operational isolation of columns 422 is maintain through independent control of BLs 706. Programming transistors 1102 and isolation switch 1110 form a circuit 1112 that is shared with cells 402 in one row 424.

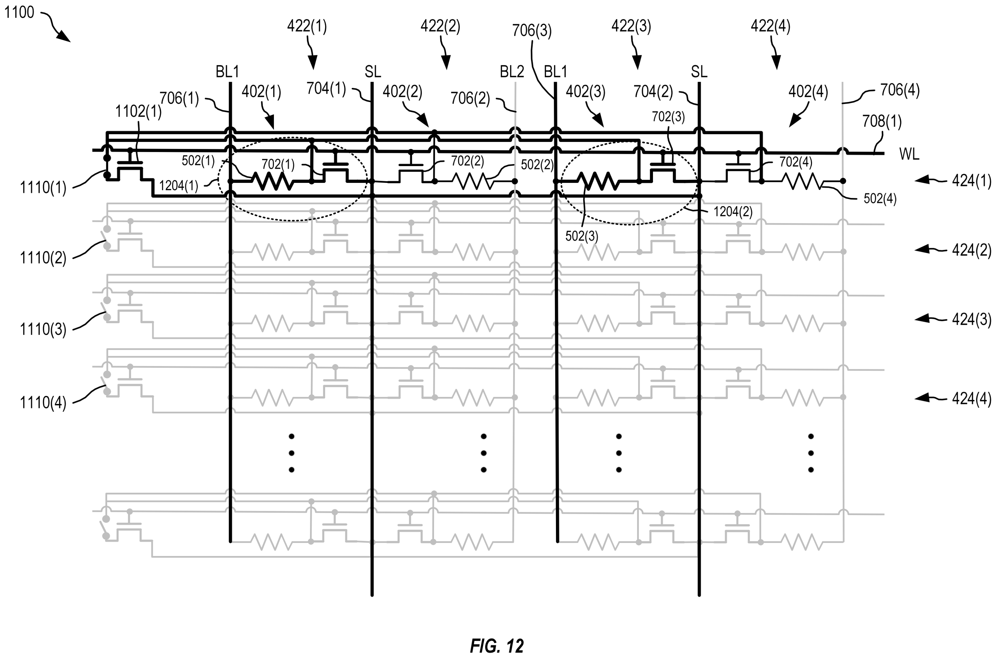

FIG. 12 is a circuit diagram illustrating a programming cycle of 2T1R memory array architecture 1100 of FIG. 11, in embodiments. In this example, cells 402(1) and 402(3) (e.g., indicated by dashed ellipses 1204(1) and 1204(2)) of columns 422(1) and 422(3) of row 424(1) are programmed simultaneously when isolation switch 1110(1) is closed, WL 708(1) is high, SL 704(1) and SL 704(2) are set to zero, and BL 706(1) and BL 706(3) are set to a corresponding programming voltage for cells 402(1) and 402(3), respectively. BL 706(2) and BL 706(4) are set to specific voltages to prevent programming of cells 402(2) and 402(4), respectively. Additional programming transistors 1102(1) is turned on to enable additional programming current during the programming of memristors 502(1) and 502(3) of row 424(1). Other isolation switches 1110 are open, thereby isolating other programming transistors 1102 of other rows 424.

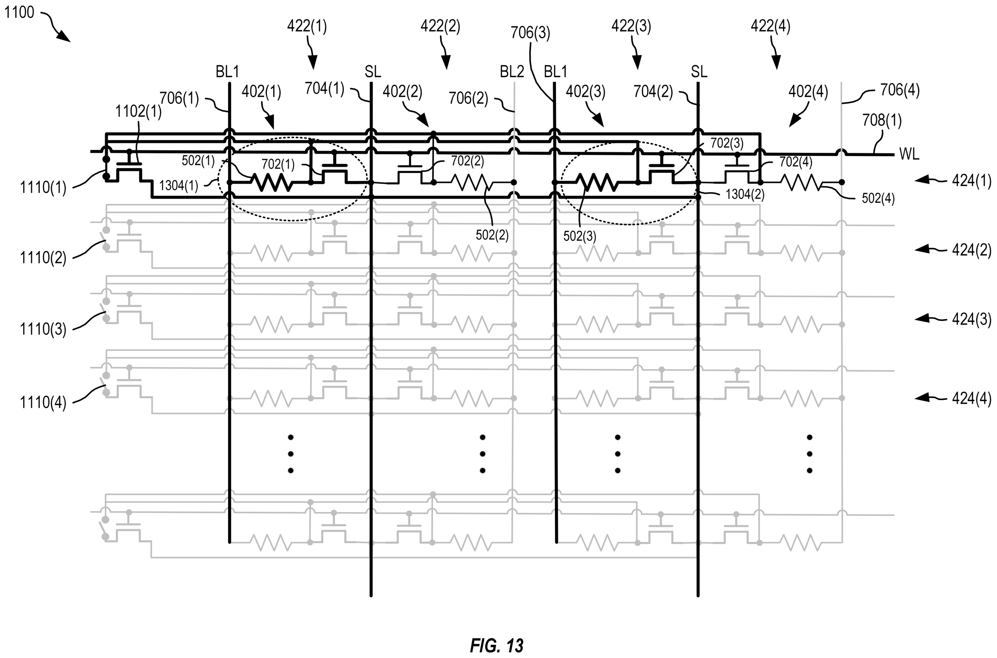

FIG. 13 is a circuit diagram illustrating a reset cycle of 2T1R memory array architecture 1100 of FIG. 11, in embodiments. In this example, cells 402(1) and 402(3) (e.g., indicated by dashed ellipses 1304(1) and 1304(2)) of columns 422(1) and 422(3) of row 424(1) are simultaneously reset when isolation switch 1110(1) is closed, WL 708(1) is high, SL 704(1) and 704(2) and BL 706(2) and 706(4) are set to a reset voltage, and BL 706(1) and BL 706(3) are set to zero. Additional programming transistor 1102(1) is turned on to enable additional reset current during the reset of memristors 502(1) and 502(3) of row 424(1). Other isolation switches 1110 are open, thereby isolating other programming transistors 1102 of other rows 424.

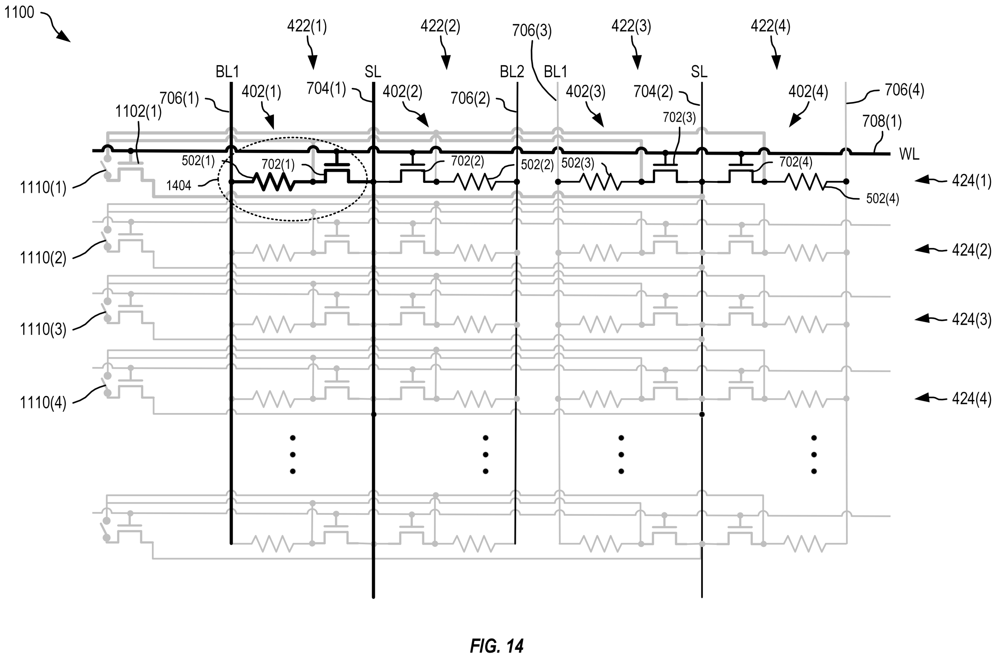

FIG. 14 is a circuit diagram illustrating a read cycle of 2T1R memory array architecture 1100 of FIG. 11, in embodiments. In this example, cell 402(1) (e.g., indicated by dashed ellipse 1404) of column 422(1) and row 424(1) is read when isolation switch 1110(1) is closed, WL 708(1) is high, SL 704(1) and 704(2) are zero, BL 706(1) is set to a read voltage, and BL 706(2) - 706(4) are set to zero. Additional programming transistor 1102(1) is turned off to disable additional read current during the read of memristor 502(1) of row 424(1). Other isolation switches 1110 are also open, thereby isolating all programming transistors 1102 of other rows 424.

FIG. 15 is a circuit diagram of a portion of one example 2T1R memory array architecture 1500 with additional programming transistors 1502 that are each shared between multiple cells 402 of one row 424 of the array, and controlled by a separate WL 1514(1), in embodiments. In the example of FIG. 15, adjacent cells are formed as a cell pair 1504 and share a common SL 704. Cell pair 1504(1) is formed of cells 402(1) and 402(2) and cell pair 1504(2) is formed of cell 402(3) and cell 402(4). Programming transistors 1502 and isolation switch 1510 form a circuit 1512 that is shared with cells 402 in one row 424. Advantageously, two cells 402 of cell pair 1104 may be programmed simultaneously, where a voltage applied to the corresponding BL 706 controls programming conditions (e.g., values) of memristor 502. For example, to program memristors 502(1) and 502(2) with different values, a first voltage corresponding to a first value is applied to BL 706(1) and a second voltage corresponding to a second value is applied to BL 706(2) during a programming cycle of cell pair 1104.

One drawback of 2T1R memory array architecture 1100 of FIG. 11, is that accuracy of programming of each memristor 502 is reduced because of the shared use of one WL 708 for each row, and the permanent connectivity between cell transistors 702(1) and 702(3) and between cell transistors 702(2) and 702(4). In the embodiment of FIG. 11, single WL 708 causes additional programming transistor 1102 and cell transistors 702(1)-(4) to turn on together, irrespective of which cell 402 is being programmed.

2T1R memory array architecture 1500 is similar to 2T1R memory array architecture 1100 of FIG. 11, and includes additional programming transistors 1502 that are each shared between multiple cells 402 of one row 424. Each cell 402 has one cell transistor 702 and one memristor 502 that are connected in series between SL 704 and a corresponding BL 706. Additional programming transistors 1502 are positioned external to a main body 1508 of cells 402 of 2T1R memory array architecture 1500. Accordingly, a size of additional programming transistors 1502 is not restricted and avoids causing fabrication non-uniformity of main body 1508. Since main body 1508 of 2T1R memory array architecture 1500 is similar to a conventional 1T1R memory array, the risk of device fabrication non-uniformity and the corresponding risk of reliability degradation is not increased by the inclusion of additional programming transistors 1502.

2T1R memory array architecture 1500 improves the programming accuracy over 2T1R memory array architecture 1100 by providing multiple WLs 1514(1)-(3) per row 424, instead of the single WL 708 of FIG. 11. For each row, WL 1514(1) connects only to a gate of additional programming transistor 1502, WL 1514(2) connects to gates of cell transistors 702(1) and 702(4) of columns 422(1) and 422(4), respectively, and WL 1514(3) connects to gates of cell transistors 702(2) and 702(3) of columns 422(2) and 422(3), respectively.

Advantageously, the separate control of additional programming transistor 1502, cell transistors 702(1) and 702(4), and cell transistors 702(2) and 702(3) improves programming accuracy of memristors 502; however, the multiple WLs 1514 require additional routing space as compared to 2T1R memory array architecture 1100.

FIG. 16 is a circuit diagram of a portion of one example 2T1R memory array architecture 1600, that is similar to 2T1R memory array architecture 1500 of FIG. 15, but has fewer WL 1614, in embodiments. In the example of FIG. 16, adjacent cells are formed as a cell pair 1604 and share a common SL 704. Cell pair 1604(1) is formed of cells 402(1) and 402(2) and cell pair 1604(2) is formed of cell 402(3) and cell 402(4). Programming transistors 1602 and isolation switch 1610 form a circuit 1612 that is shared with cells 402 in one row 424.

2T1R memory array architecture 1600 is similar to 2T1R memory array architecture 1500 of FIG. 15, and includes additional programming transistors 1602 that are each shared between multiple cells 402 of one row 424. Each cell 402 has one cell transistor 702 and one memristor 502 that are connected in series between SL 704 and a corresponding BL 706. Additional programming transistors 1602 are positioned external to a main body 1608 of cells 402 of 2T1R memory array architecture 1600. Accordingly, a size of additional programming transistors 1602 is not restricted and avoids causing fabrication non-uniformity of main body 1608. Since main body 1608 of 2T1R memory array architecture 1600 is similar to a conventional 1T1R memory array, the risk of device fabrication non-uniformity and the corresponding risk of reliability degradation is not increased by the inclusion of additional programming transistors 1502.

2T1R memory array architecture 1600 requires less additional routing space for WLs as compared to 2T1R memory array architecture 1500, since fewer WL are required. However, with fewer WL, programming accuracy of cells 402 of 2T1R memory array architecture 1600 is reduced as compared to 2T1R memory array architecture 1500, but programming accuracy of 2T1R memory array architecture 1600 is better than programming accuracy of 2T1R memory array architecture 1100 of FIG. 11. For each row, WL 1614(1) connect to a gate of additional programming transistor 1602 and to gates of cell transistors 702(1) and 702(4) of columns 422(1) and 422(4), respectively, and WL 1614(2) connects to gates of cell transistors 702(2) and 702(3) of columns 422(2) and 422(3), respectively.

FIG. 17 is a circuit diagram of 2T1R memory array architecture 1100 of FIG. 11 illustrating a read mode, in embodiments. In the read mode, isolation switch 1110 is open and WL 708 is inactive, causing additional programming transistors 1102 to be disabled such that cell transistors 702 and memristor 502 are controlled by SL 704 and BL 706 as for a conventional 1T1R memory array architecture. Accordingly, additional programming transistors 1102 do not affect the read mode of 2T1R memory array architecture 1100.

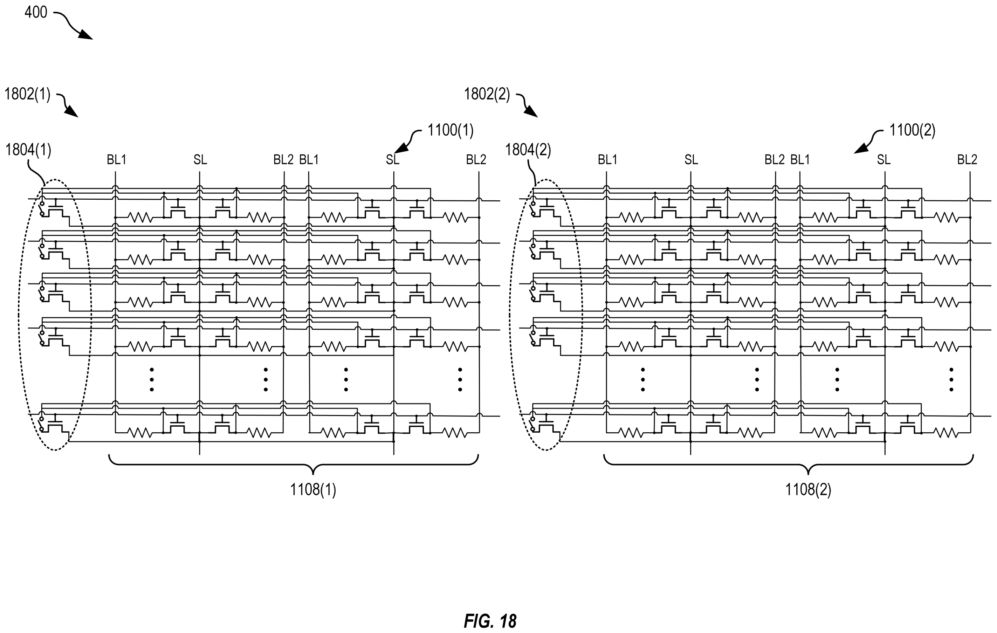

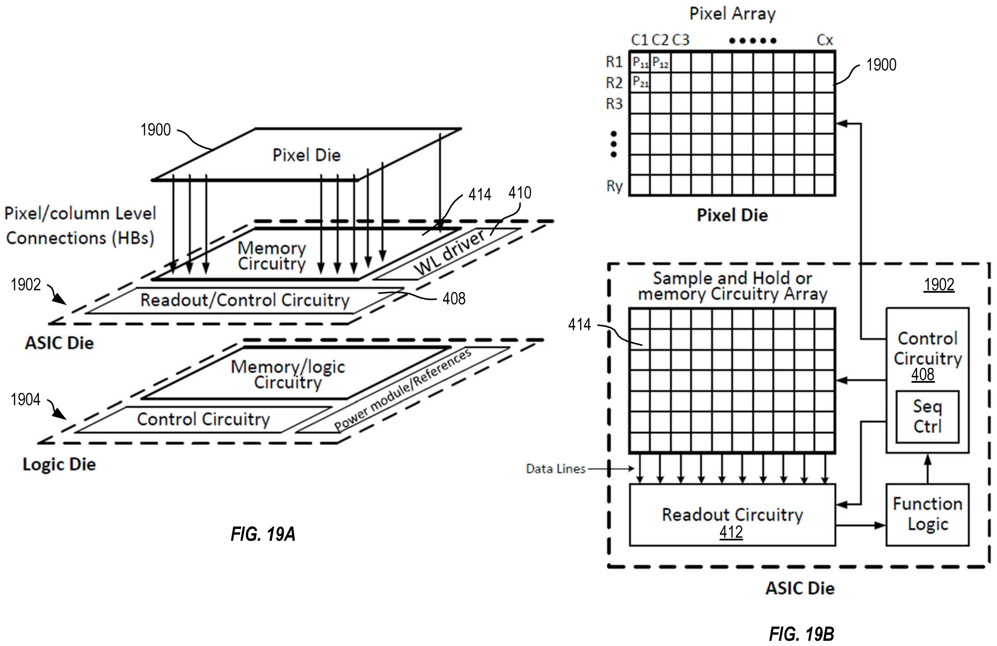

FIG. 18 is a circuit diagram illustrating two memory cell groups 1802(1) and 1802(2) of 2T1R memory array architecture 1100 of FIG. 11, that form at least part of cross-bar array 414 of FIG. 4, in embodiments. As described above, cross-bar array 414 forms part of computational block 406 of computational memory 400. Additional programming transistor groups 1804(1) and 1804(2) (indicated by ellipses) are positioned external to main body 1108 of 2T1R memory array architectures 1100(1) and 1100(2), respectively. Multiple cell groups 1802 may be integrated on an ASIC die (e.g., see ASIC die 1902 of FIG. 19A) to form computational memory 400 of FIG. 4 as described above. Particularly, each additional programming transistor group 1804(1) and 1802(2) is positioned near its corresponding main body 1108(1) and 1108(2), respectively.

FIG. 19A is a schematic diagram illustrating one example integration of computational memory 400 of FIG. 4 with an image sensor 1900, in embodiments. FIG. 19B is a schematic diagram illustrating example functionality between image sensor 1900 and ASIC die 1902 of FIG. 19A, in embodiments. FIGs. 19A and 19B are best viewed together with the following description. Image sensor 1900 may also represent a photo-diode array sensor stack.

Computational memory 400 and image sensor 1900 (e.g., a pixel die) may be electrically coupled through wafer-to-wafer hybrid bonding (HB) connectors on an ASIC die 1902. ASIC die 1902 may couple with a logic die 1904. A readout/control circuitry (e.g., control circuitry 408, FIG. 4) controls operation of cross-bar array 414 to process images captured by image sensor 1900 through DNN 300. For example, DNN 300 may implement inference of images captured by image sensor 1900. As shown in FIG. 19B, control circuitry 408 controls input of data from image sensor 1900 into cross-bar array 414 based on a sequence controller. Output peripheral circuits 412 convert the output of cross-bar array 414 into data used by a function logic and/or further processing elements, such as by memory circuits of a logic die 1904. This architecture realizes AI functionality "in sensor" (e.g., configured as part of a sensor circuit). When the AI functionality is in sensor, the data being sent from image sensor 1900 to a host device may be reduced to only meta data. This significantly reduces a required data bandwidth and reduces computational work load on the host device.

Advantageously, by combining computational memory 400 with image sensor 1900, on-chip object classification or object identification may be implemented to detect one or more objects in the captured image based on a predefined set of objects stored in a memory (e.g., look up table) based on CNN output parameters.

2T1R memory array architectures 1100, 1500, and 1600 may be implemented to improve the signal-to-noise-ratio (SNR) of computational memory 400 that performs matrix vector multiplication. As described above, input peripheral circuits 510 include at least one DAC and output peripheral circuits 512 include at least one ADC coordinated by control circuitry 508. Cross-bar array 514 includes additional programming transistors 1102 and isolation switches 1110 that cooperate to increase a driving current to increase level separation of values written to individual memristors 502 of computational memory 400. Isolation switch 1110 decouples additional programming transistor 1102 when computational memory 400 is not in write mode, such that 2T1R memory array architecture 1100/1500/1600 operates without significant interference from additional programming transistors 1102 in read mode. The gate voltage, applied by WL 708/1514/1614, may be controlled independently from the value applied to cell 402.

As shown in FIG. 5, cells 402 may be implemented using memristors 502; however, cells 402 may be implemented with other two-terminal component that has a programmable memory function. Computation is done in the analog domain (e.g., either current domain or charge domain), and computational memory 400 uses both analog and digital circuits.

As described above, when combined with image sensor 1900, computational memory 400 may implement DNN 300 to provide an on-chip object classification or identification circuit of a captured image, and may and detect one or more objects in the captured image based on predefined set of objects stored in a memory (e.g., look up table). For example, the memory may store pretrained weights that control DNN 300 to recognize one or more objects in the captured image.

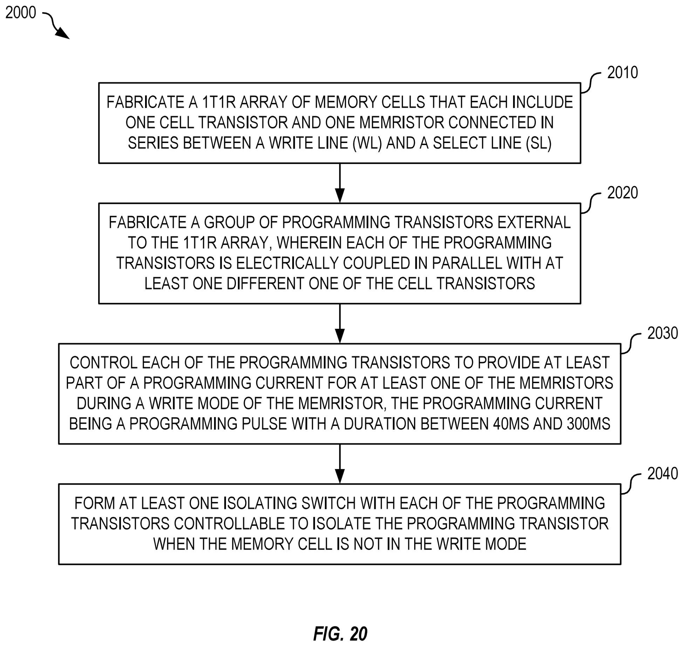

FIG. 20 is a flowchart illustrating one example method 2000 for high signal-to-noise-ratio programming of memory cell for in-memory computing. Method 2000 may be implemented to fabricate computational memory 500 of FIG. 5.

In block 2010, method 2000 fabricates a 1T1R array of memory cells that each include one cell transistor and one memristor connected in series between a BL and a SL. In one example of block 2010, cross-bar array 514 is fabricated where each cell 402 includes memristor 502 and cell transistor 702 connected in series between SL 704 and BL 706.

In block 2020, method 2000 fabricates a group of programming transistors external to the 1T1R array, wherein each of the programming transistors is electrically coupled in parallel with at least one different one of the cell transistors. In one example of block 2020, additional programming transistors 1102 are fabricated external to cross-bar array 514, where each programming transistor 1102 connects in parallel with at least one cell transistors 702 of one row 424.

In block 2030, method 2000 controls each of the programming transistors to provide at least part of a programming current for at least one of the memristors during a write mode of the memristor. In one example of block 2030, programming transistors 1102 are controlled to increase a programming current through memristor 502 during a write mode of cell 402.

In block 2040, method forms at least one isolating switch with each of the programming transistors controllable to isolate the programming transistor when the memory cell is not in the write mode. In one example of block 2040, isolation switches 1110 are formed external to cross-bar array 514 and with programming transistors 1102, where each isolation switch 1110 is controllable to isolate programming transistors 1102 from the at least one cell transistors 702 when cell 402 is not in a write mode.

Advantageously, method 2000 forms computational memory 400 with minimal risk of device fabrication non-uniformity and minimal risk of reliability degradation, since additional programming transistors 1102 are formed external to cross-bar array 514.

It should be noted that the matter contained in the above description or shown in the accompanying drawings should be interpreted as illustrative and not in a limiting sense. The following claims are intended to cover all generic and specific features described herein, as well as all statements of the scope of the present method and system, which, as a matter of language, might be said to fall therebetween.

## Claims

1. An in-memory computing system (200) with high signal-to-noise-ratio memory cell programming, comprising:
a computational block (406) formed with a cross-bar array (414, 514) of memory cells (402), wherein each memory cell (402) includes a cell transistor (702) and a memristor (502) connected in series between a select line, SL, (704) and a bit line, BL, (706); and
a group of programming transistors (1102) located outside a main body of the cross-bar array (514) and fewer in number than the memory cells, wherein each programming transistor is selectively connected in parallel with a plurality of cell transistors (702) of a common row during a write mode of the memory cell and is isolated from the cell transistors when the memory cells are not in the write mode.

2. The in-memory computing system of claim 1, further comprising, for each programming transistor (1102), an isolating switch connected in series with the programming transistor and configured to open when the memory cells are not in the write mode.

3. The in-memory computing system of claim 2, wherein, in a read mode, the isolating switch is open and a gate of the programming transistor is inactive such that each memory cell operates as a 1T1R cell controlled by the SL and BL of a corresponding column.

4. The in-memory computing system of claim 2 or 3, wherein the programming transistor is controlled to allow a programming conductance below 10mS.

5. The in-memory computing system of any one of claims 1 to 4, wherein each row includes a first word line coupled to gates of the programming transistors of the row, a second word line coupled to gates of first and fourth cell transistors of the row, and a third word line coupled to gates of second and third cell transistors of the row.

6. The in-memory computing system of any one of claims 1 to 4, wherein each row includes a first word line coupled to gates of the programming transistors and to gates of first and fourth cell transistors of the row, and a second word line coupled to gates of second and third cell transistors of the row.

7. The in-memory computing system of any one of claims 1 to 6, wherein during the write mode the programming transistor (1102) is paralleled with the cell transistors (702) to increase separation between programmed conductance levels of the memristor such that at least sixteen discernable levels are achieved when the programming transistors are isolated in a read mode;
particularly wherein the increased separation between programmed conductance levels increases accuracy of in-memory computation in a current domain.

8. The in-memory computing system of any one of claims 1 to 7, wherein two adjacent memory cells on one row of the cross-bar array form a cell pair that shares one SL and one programming transistor connects in parallel to both cell transistors of the cell pair.

9. The in-memory computing system of claim 8, wherein the two adjacent memory cells are programmed simultaneously using current provided at least in part by the one programming transistor;
particularly wherein programming conditions of memristors of the two adjacent memory cells are controlled by independently applied BL voltages during a common programming period.

10. The in-memory computing system of any one of claims 1 to 9, wherein the memristor is a ReRAM.

11. The in-memory computing system of any one of claims 1 to 10, wherein in-memory computation is performed by the cross-bar array in one of a current domain and a charge domain.

12. The in-memory computing system of any one of claims 1 to 11, the computational block and the group of programming transistors being fabricated as an ASIC die for on-chip object classification of images captured by one of an image sensor (202, 1900) and a photo-diode array sensor stack.

13. The in-memory computing system of any one of claims 1 to 12, wherein each programming transistor is controllable to conduct at least part of a programming current for at least one of the memristors during a write mode.

14. The in-memory computing system of any one of claims 1 to 13, wherein a size of each programming transistor is greater than a size of any one of the cell transistors.

15. The in-memory computing system of any one of claims 1 to 14, further comprising:
a second computational block formed with a second cross-bar array of second memory cells, wherein each second memory cell includes a second cell transistor and a second memristor connected in series; and
a second group of second programming transistors positioned external to the cross-bar array and the second cross-bar array, wherein each second programming transistor connects in parallel with at least one second cell transistor during the write mode of the second memory cell.
